(19) Europäisches Patentamt
European Patent Office
Office européen des brevets

(11) **EP 3 215 472 B1**

(12) **EUROPEAN PATENT SPECIFICATION**

(45) Date of publication and mention
of the grant of the patent:
**19.02.2020 Bulletin 2020/08**

(21) Application number: **15795086.6**

(22) Date of filing: **04.11.2015**

(51) Int Cl.:
*C03C 21/00* (2006.01)      *B32B 17/06* (2006.01)
*B32B 17/10* (2006.01)      *H01L 51/52* (2006.01)
*C03C 15/00* (2006.01)      *C03C 17/00* (2006.01)
*C03C 17/30* (2006.01)      *C03C 17/32* (2006.01)

(86) International application number:
**PCT/US2015/058943**

(87) International publication number:
**WO 2016/073551 (12.05.2016 Gazette 2016/19)**

(54) **BENDABLE GLASS ARTICLES WITH ALKALI-FREE GLASS ELEMENTS**

BIEGBARE GLASARTIKEL MIT ALKALIFREIEN GLASELEMENTEN

ARTICLES EN VERRE PLIABLES AVEC ÉLÉMENTS EN VERRE SANS ALCALI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.11.2014 US 201462074940 P**

(43) Date of publication of application:
**13.09.2017 Bulletin 2017/37**

(60) Divisional application:
**20151439.5**

(73) Proprietor: **Corning Incorporated**
**Corning, New York 14831 (US)**

(72) Inventors:
• **GROSS, Timothy Michael**
**Corning, New York 14830 (US)**
• **SHUSTACK, Paul John**
**Elmira, New York 14905 (US)**

(74) Representative: **Sturm, Christoph**
**Quermann - Sturm - Weilnau**
**Patentanwälte Partnerschaft mbB**
**Unter den Eichen 5**
**65195 Wiesbaden (DE)**

(56) References cited:
**WO-A1-2013/183681      US-A1- 2012 040 146**
**US-A1- 2012 223 049      US-A1- 2012 263 945**
**US-A1- 2013 109 116**

• **SEAN GARNER ET AL: "Ultra-slim flexible glass for roll-to-roll electronic device fabrication", APPLIED PHYSICS A: MATERIALS SCIENCE & PROCESSING., vol. 116, no. 2, 15 May 2014 (2014-05-15), pages 403-407, XP055239631, DE ISSN: 0947-8396, DOI: 10.1007/s00339-014-8468-2**
• **STEFFEN HOEHLA ET AL: "Active Matrix Color-LCD on 75 $\mu$ m Thick Flexible Glass Substrates", JOURNAL OF DISPLAY TECHNOLOGY, IEEE SERVICE CENTER, NEW YORK, NY, US, vol. 8, no. 6, 1 June 2012 (2012-06-01), pages 309-316, XP011441792, ISSN: 1551-319X, DOI: 10.1109/JDT.2011.2178393**

**Description**

**CROSS-REFERENCE TO RELATED APPLICATIONS**

This application claims the benefit of priority under 35 U.S.C. § 119 of U.S. Provisional Application Serial No. 62/074,940 filed on November 4, 2014.

**TECHNICAL FIELD**

The disclosure generally relates to bendable glass articles, stack assemblies and electronic device assemblies, and various methods for making them. More particularly, the disclosure relates to bendable versions of these articles and assemblies containing alkali-free glass elements, along with methods for making them.

**BACKGROUND**

Flexible versions of products and components that are traditionally rigid in nature are being conceptualized for new applications. For example, flexible electronic devices can provide thin, lightweight and flexible properties that offer opportunities for new applications, for example curved displays and wearable devices. Many of these flexible electronic devices utilize flexible substrates for holding and mounting the electronic components of these devices. Polymeric foils have some advantages including resistance to fatigue failure, but suffer from marginal optical transparency, lack of thermal stability and limited hermeticity. When polymeric foils are employed as backplanes or substrates for electronic devices, their limited temperature resistance significantly limits processing and manufacturing of the electronic components employed in these devices.

Some of these electronic devices also can make use of flexible displays. Optical transparency and thermal stability are often important properties for flexible display applications. In addition, flexible displays should have high fatigue and puncture resistance, including resistance to failure at small bend radii, particularly for flexible displays that have touch screen functionality and/or can be folded.

Conventional flexible glass materials offer many of the needed properties for flexible substrate and/or display applications. However, efforts to harness glass materials for these applications have been largely unsuccessful to date. Generally, glass substrates can be manufactured to very low thickness levels (< 25 $\mu$m) to achieve smaller and smaller bend radii. However, these "thin" glass substrates suffer from limited puncture resistance. At the same time, thicker glass substrates (> 150 $\mu$m) can be fabricated with better puncture resistance, but these substrates lack suitable fatigue resistance and mechanical reliability upon bending. In addition, some conventional glass substrate compositions have the disadvantage of containing relatively high alkali ion levels. Glass substrates made with these compositions are susceptible to alkali ion migration that can degrade the performance of the electronic devices and components mounted on these substrates.

Thus, there is a need for glass materials, components, assemblies and device configurations for reliable use in flexible backplane, substrate and/or display applications and functions, particularly for flexible electronic device applications.

Prior art is disclosed by US 2013/109116A1, US 2012/040146 A1, WO 2013/183681 A1, US 2012/263945 A1 and US 2012/223049 A1.

**SUMMARY**

The invention provides a bendable stack assembly according to claim 1.

According to some aspects, the composition of the glass element has less than 0.5 mol% of each of $Li_2O$, $Na_2O$, $K_2O$, $Rb_2O$ and $Cs_2O$.

According to an aspect, a bendable stack assembly is provided that includes a glass element having a composition substantially free of alkali ions, an elastic modulus of about 40 GPa to about 100 GPa, a $K_{IC}$ fracture toughness of at least 0.6 MPa·m$^{1/2}$, a thickness from about 20 $\mu$m to about 100 $\mu$m, a first primary surface substantially in tension upon a bending of the element, and a second primary surface substantially in compression upon the bending. The glass element also includes a protect layer on the first primary surface.

According to another aspect, the glass element also includes a protect layer on the first primary surface. In addition, the glass element is characterized by an absence of failure after the element has been subjected to 200,000 cycles of the bending at a bend radius of about 15 mm at about 25°C and about 50% relative humidity.

It should be understood that the required bend strength of at least 1000 MPa at a failure probability of 2% or greater is based on an extrapolation of Weibull bend test data that excludes data from samples with reduced strength values associated with testing-related artifacts.

**EP 3 215 472 B1**

The invention provided further a bendable electronic device assembly according to claim 6.

According to certain aspects, the bendable electronic device assembly further includes a bendable cover over the plurality of electronic components, the cover having a thickness from about 25 μm to about 125 μm, a first primary surface and a second primary surface. The cover also includes (a) a first glass layer having an optical transmissivity of at least 90% and a first primary surface; and (b) a compressive stress region extending from the first primary surface of the first glass layer to a first depth in the first glass layer, the region defined by a compressive stress of at least about 100 MPa at the first primary surface of the first glass layer. In addition, the bendable cover is also characterized by: (a) an absence of failure when the cover is held at a bend radius of about 15 mm for at least 60 minutes at about 25°C and about 50% relative humidity; (b) a puncture resistance of greater than about 1.5 kgf when the first primary surface of the cover is supported by (i) an approximately 25 μm thick pressure-sensitive adhesive having an elastic modulus of less than about 1 GPa and (ii) an approximately 50 μm thick polyethylene terephthalate layer having an elastic modulus of less than about 10 GPa, and the second primary surface of the cover is loaded with a stainless steel pin having a flat bottom with a 200 μm diameter; and (c) a pencil hardness of greater than or equal to 8H. According to some aspects, the composition of the first glass layer of the bendable cover has less than 0.5 mol% of each of Li$_2$O, Na$_2$O, K$_2$O, Rb$_2$O and Cs$_2$O.

In some embodiments, the bendable electronic device assembly further includes a bendable encapsulant located beneath the cover and joined to the backplane, the encapsulant configured to encapsulate the plurality of electronic components. In certain aspects, the encapsulant has a thickness from about 25 μm to about 125 μm and further includes: (a) a second glass layer having an optical transmissivity of at least 90%, and a first primary surface; and (b) a compressive stress region extending from the first primary surface of the second glass layer to a first depth in the second glass layer, the region defined by a compressive stress of at least about 100 MPa at the first primary surface of the second glass layer. The encapsulant is further characterized by an absence of failure when the encapsulant is held at a bend radius of about 15 mm for at least 60 minutes at about 25°C and about 50% relative humidity. In some implementations, the second layer of the bendable encapsulant has a glass composition that is substantially free of alkali ions. According to some aspects, the composition of the bendable encapsulant has less than 0.5 mol% of each of Li$_2$O, Na$_2$O, K$_2$O, Rb$_2$O and Cs$_2$O.

In a further aspect of the disclosure, the bendable electronic device assembly can further include a bendable encapsulant located beneath the cover and joined to the backplane, the encapsulant further configured to encapsulate the plurality of electronic components; and a protect layer on the first primary surface of the encapsulant. In this aspect, the encapsulant is further characterized by: a glass composition substantially free of alkali ions and having an optical transmissivity of at least 90%; an elastic modulus of about 40 GPa to about 100 GPa; a final thickness from about 20 μm to about 100 μm; a first primary surface substantially in tension upon a bending of the encapsulant; a second primary surface substantially in compression upon the bending, the primary surfaces characterized by a prior material removal to the final thickness from an initial thickness that is at least 20 μm greater than the final thickness; and an absence of failure when the encapsulant is held during the bending at a bend radius of about 15 mm for at least 60 minutes at about 25°C and about 50% relative humidity.

Additional features and advantages will be set forth in the detailed description which follows, and in part will be readily apparent to those skilled in the art from that description or recognized by practicing the embodiments as described herein, including the detailed description which follows, the claims, as well as the appended drawings.

It is to be understood that both the foregoing general description and the following detailed description are merely exemplary, and are intended to provide an overview or framework to understanding the nature and character of the claims. The accompanying drawings are included to provide a further understanding, and are incorporated in and constitute a part of this specification. The drawings illustrate one or more embodiments, and together with the description serve to explain principles and operation of the various embodiments. Directional terms as used herein-for example, up, down, right, left, front, back, top, bottom-are made only with reference to the figures as drawn and are not intended to imply absolute orientation.


**BRIEF** DESCRIPTION OF THE DRAWINGS

FIG. 1 is a Weibull plot of failure probability vs. load at failure for a group of flexible glass samples having etched and indented primary surfaces and another group of flexible glass samples having etched primary surfaces.
FIG. 2 is perspective view of a bendable stack assembly comprising an alkali-free glass element having a composition substantially free of alkali ions and a protect layer according to an aspect of this disclosure.
FIG. 2A is a cross-sectional view of the stack assembly depicted in FIG. 2.
FIG. 2B is a cross-sectional view of the stack assembly depicted in FIG. 2, upon a bending of the assembly.
FIGS. 3 and 3A are schematic views depicting design configurations for bendable stack assemblies with particular regard to the maximum bend radii, elastic modulus and thickness of the alkali-free glass element employed in these assemblies according to further aspects of the disclosure.

FIG. 4 is perspective view of an electronic device assembly comprising a bendable backplane having an alkali-free glass composition, a protect layer and electronic devices on the backplane according to an additional aspect of the disclosure.

FIG. 4A is a cross-sectional view of the electronic device assembly depicted in FIG. 4, upon a bending of the assembly.

FIG. 5 is a perspective view of an electronic device assembly, comprising a bendable backplane having an alkali-free glass composition, a protect layer, electronic devices on the backplane, a bendable cover over the electronic components, and a bendable encapsulant beneath the cover and joined to the backplane that encapsulates the electronic components.

FIG. 5A is a cross-sectional view of the electronic device assembly depicted in FIG. 5, upon a bending of the assembly.

## DETAILED DESCRIPTION

Reference will now be made in detail to the present preferred embodiments, examples of which are illustrated in the accompanying drawings. Whenever possible, the same reference numerals will be used throughout the drawings to refer to the same or like parts. Ranges can be expressed herein as from "about" one particular value, and/or to "about" another particular value. When such a range is expressed, another embodiment includes from the one particular value and/or to the other particular value. Similarly, when values are expressed as approximations, by use of the antecedent "about," it will be understood that the particular value forms another embodiment. It will be further understood that the endpoints of each of the ranges are significant both in relation to the other endpoint, and independently of the other endpoint.

Among other features and benefits, the stack assemblies, glass elements and glass articles (and the methods of making them) of the present disclosure provide mechanical reliability (e.g., in static tension and fatigue, as well as in dynamic bending over many cycles) at small bend radii. The small bend radii and reduced susceptibility to alkali ion migration are particularly beneficial when the stack assembly, glass element, and/or glass article, is/are used as a substrate or backplane component within a foldable display. For example, the element, assembly or article can be employed in a display in which a portion of the display is folded over on top of another portion of the display and the substrate or backplane contains electronic components. More generally, the stack assemblies, glass elements and/or glass articles, may be used as one or more of: a cover on the user-facing portion of a foldable display, a location wherein puncture resistance is particularly important; a substrate, disposed internally within the device itself, on which electronic components are disposed; or elsewhere in a foldable display device. Alternatively, the stack assembly, glass element, and or glass article, may be used in a device not having a display, but one wherein a glass layer is used for its beneficial properties and is folded, in a similar manner as in a foldable display, to a tight bend radius.

According to an aspect of the disclosure, a bendable stack assembly is provided that includes a glass element having a composition substantially free of alkali ions, an elastic modulus of about 40 GPa to about 100 GPa and a final thickness from about 20 $\mu$m to about 100 $\mu$m. The assembly also includes at least one protect layer over one or more primary surfaces of the glass element. The final thickness of the glass element is the thickness of the element after a material removal process, e.g., an etching process that removes at least 10 microns from each surface of the glass element.

The ability of an alkali-free, bendable glass article to bend without failure under static and/or cyclic conditions depends at least in part on the strength of the article. The strength of the article often depends on the size and distribution of the flaws in the articles relative to the stress field applied to the articles. During manufacturing, alkali-free glass substrates are cut, singulated or otherwise sectioned to final or near-final shapes. These processes, and the handling associated with them, often introduce flaws into the articles, degrading the strength and toughness of the articles. Consequently, alkali-free glass plates often demonstrate strength levels of 250 MPa or less. A fracture toughness ($K_{IC}$) value of about 0.8 MPa·m$^{1/2}$ is typical of alkali-free glass compositions. By employing Equation (1) below, it is possible to estimate a maximum flaw size of about 2.6 microns for such articles subjected to handling and manufacturing-related damage:

$$K_{IC} = Y^*\sigma^*a^{1/2} \qquad\qquad (1)$$

where $a$ is the maximum flaw size and $Y$ is an empirically determined crack shape factor, about 1.12$^*\pi^{1/2}$ for surface scratches typically associated with singulation and manufacturing-related handling damage.

Material removal processes, such as acid etch procedures performed after singulation, can significantly improve the flaw distributions within alkali-free glass articles (and other glass compositions) by reducing the density and size of the flaws. Other approaches employed by those skilled in the field can be employed to remove material from the glass (e.g., laser etching). According to an aspect of the disclosure, these material removal processes can enhance the strength of the alkali-free glass elements to strength levels of 1000 MPa or greater. In view of Equation (1), the material removal process reduces the maximum flaw size, $a$, to about 162 nm.

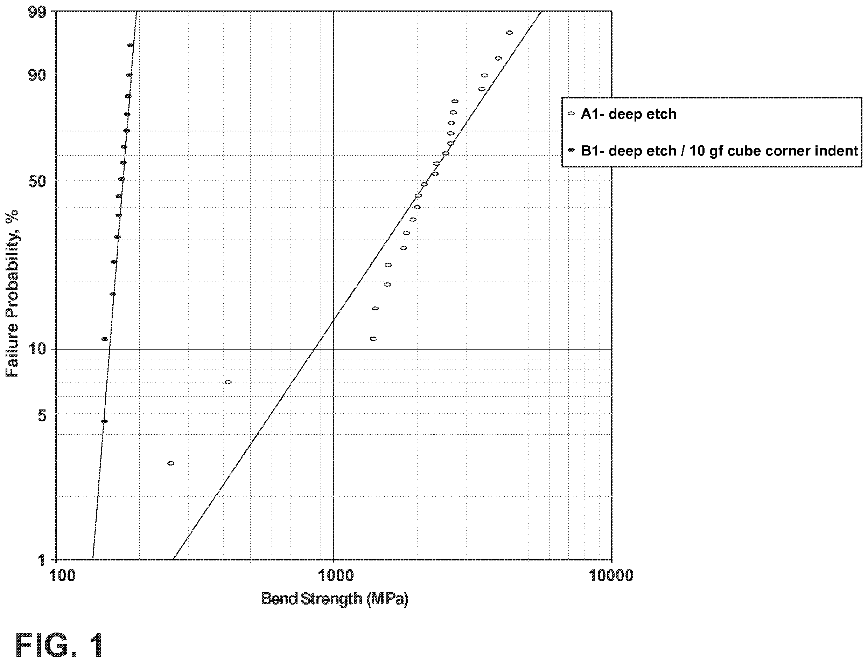

As handling and singulation can cause damage to the articles, it is also expected that minimal and even careful handling of alkali-glass articles (and articles having other glass compositions) after the material removal processes can also significantly reduce the enhanced strength of the articles obtained through material removal procedures. FIG. 1 presents a Weibull plot of failure loads and failure probabilities that demonstrates this point. In particular, a group of non-strengthened, Corning Gorilla® glass articles subjected to a material removal process and small cube corner indentation (i.e., the "B1 - deep etch" group) demonstrated significantly lower strength values compared to a group of samples having the same composition and material removal process conditions (i.e., the "A1 - deep etch" group). In FIG. 1, the tested samples had an original thickness of about 200 microns and were reduced to 75 microns in thickness by a deep acid etching procedure. In the B1 group, the samples were subjected to a cube corner indentation at about 10 gf.

Referring again to FIG. 1, the A1 group demonstrated strength values in excess of 1000 MPa at failure probabilities of 10% or greater. Further, two data points with strength values well below 1000 MPa were deemed to be outliers that were inadvertently damaged during testing-related handling. As a result, the Weibull modulus (i.e., the slope of failure probability vs. stress at failure) depicted in FIG. 1 for the A1 group is conservative in the sense that it also includes the two outliers. If the outliers are neglected from the group, the resulting Weibull modulus indicates that estimated strength values in excess of 1000 MPa are likely at failure probabilities of 2% or higher. In comparison, the B1 group of samples demonstrated strength values of 200 MPa or less for all failure probabilities. At a failure probability of 2%, the expected strength is about 150 MPa. It is expected that the data generated in FIG. 1 associated with the non-strengthened Corning Gorilla® glass samples will be comparable to strength data generated with alkali-free glass samples. While the strength values and Weibull moduli may differ slightly between a group of samples having an alkali-free glass composition and a non-strengthened Corning Gorilla® glass composition, the observed trend in the reduction in strength associated with the cube corner indentation depicted in FIG. 1 is expected to be substantially equivalent.

In view of these understandings, an aspect of the disclosure is to add a protect layer to one or more surfaces of the alkali-free glass element subject to tensile stresses in the application environment. It is expected that the protect layer will ensure that the enhanced strength levels in the alkali-free glass elements are retained through additional handling and manufacturing, before installation of the glass elements in electronic devices or other articles. For example, a protect layer can be applied to the primary surface of an alkali-free glass element under tension during bending and to at least portions of the edges of the element also subjected to tensile stresses during bending of the element. In some aspects, the protect layer is applied such that minimal contact is made to the surface of the alkali-free glass element to be protected. Thin, polymeric films of materials such as polymethyl methylacrylate (PMMA) at 100 microns or less in thickness can be adhered with an adhesive layer at 100 microns or less in thickness to a primary surface of the alkali-free glass element to give it protection. In certain embodiments, the protect layer can comprise a mixture of nano-silica particulate and epoxy or urethane materials applied using any one or more of the following coating application techniques: dip, spray, roller, slot die, curtain, inkjet, offset printing, gravure, offset gravure, brush on, transfer printing, cast and cure, and other suitable processes as understood by those skilled in the operative field. Such mixtures can also be employed to protect edges of the alkali-free glass elements expected to experience tensile stresses during bending of the element in the application environment.

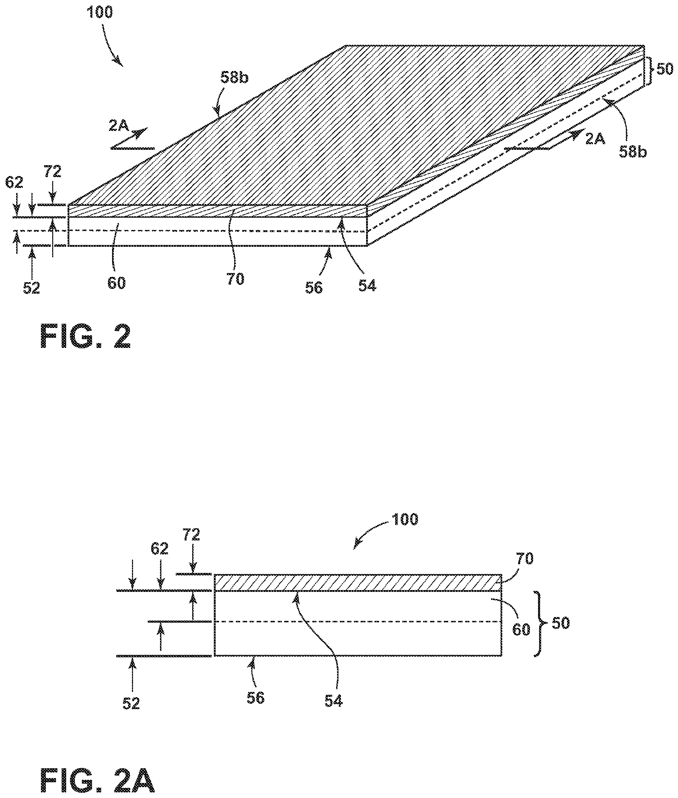

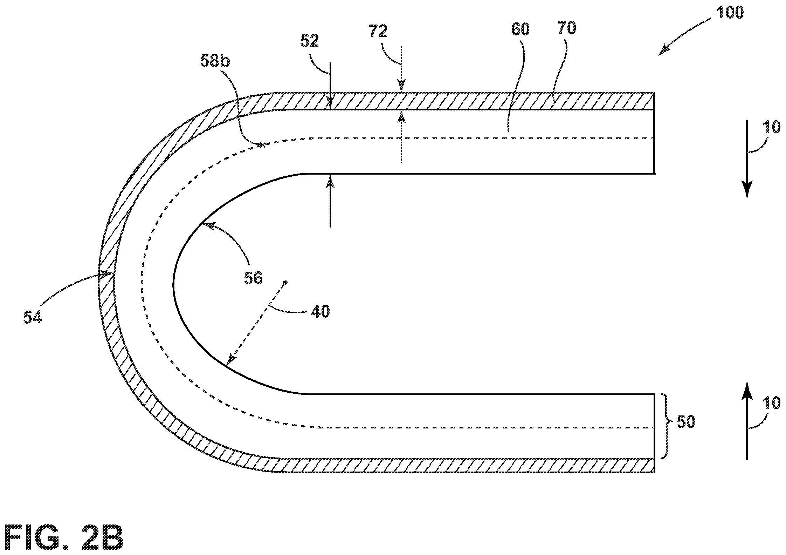

Referring to FIGS. 2-2B, a bendable stack assembly 100 is depicted according to one aspect of the disclosure. The assembly 100 includes a glass element 50 having a composition substantially free of alkali ions, an elastic modulus of about 40 GPa to about 100 GPa, a final thickness 52 from about 20 $\mu$m to about 100 $\mu$m, a first primary surface 54 substantially in tension upon a bending 10 of the element, and a second primary surface 56 substantially in compression upon the bending 10. As depicted in FIGS. 2-2B, the primary surfaces 54, 56 are characterized by a prior material removal to the final thickness 52 from an initial thickness that is at least 20 $\mu$m greater than the final thickness 52. The glass element also includes a protect layer 70 having a thickness 72 on the first primary surface 54. In addition, the glass element 50 is characterized by an absence of failure when the element 50 is held during the bending at a bend radius 40 of about 15 mm for at least 60 minutes at about 25°C and about 50% relative humidity.

According to some aspects, the composition of the glass element 50 depicted in FIGS. 2-2B has less than 0.5 mol% of each of $Li_2O$, $Na_2O$, $K_2O$, $Rb_2O$ and $Cs_2O$. In certain implementations, the alkali-free nature of the glass element 50 is characterized by less than 0.45 mol%, 0.40 mol%, 0.35 mol%, 0.30 mol%, 0.25 mol%, 0.20 mol%, 0.15 mol%, 0.10 mol% or 0.05 mol% of each of $Li_2O$, $Na_2O$, $K_2O$, $Rb_2O$ and $Cs_2O$.

In some implementations, the bendable stack assembly 100 includes a glass element 50 that is characterized by an absence of failure when the element 50 is held during bending 10 at a bend radius 40 of about 15 mm for at least 60 minutes at about 25°C and about 50% relative humidity. Even more preferably, the element 50 is characterized by an absence of failure when held during bending 10 at a bend radius of 5 mm under the same or similar test conditions. The stack assembly 100 depicted in FIGS. 2-2B is also capable of the same or similar bending radii (e.g., within about +/- 10% of the bending radii stated earlier) under other test conditions consistent with the expected application environment (e.g., humidity and/or temperature levels within about +/- 10% of the values stated earlier).

Referring again to FIGS. 2-2B, the protect layer 70 of the bendable stackable assembly 100 on the primary surface 54 of the glass element 50 can comprise various materials. Preferably, the protect layer 70 comprises a polymeric material having a thickness 72 of at least 5 microns. In some aspects, the thickness 72 of the protect layer 70 can range from 5 microns to 50 microns, depending on the thickness of the glass element 50. It is preferable to employ a protect layer 70 with a thickness 72 on the low end of the foregoing range for thinner glass elements to avoid warping of the element from shrinkage of the protect layer associated with its processing. As the thickness of the glass element is increased, according to some aspects, the thickness 72 of the protect layer 70 can also be increased within the foregoing range.

As discussed earlier, the protect layer 70 can comprise nano-silica particulate and at least one of epoxy and urethane materials. These compositions for the protect layer 70, and other suitable alternative compositions are also disclosed in U.S. Application No. 14/516,685, filed on October 17, 2014. In one preferred example, a urethane having the following composition can be employed for the protect layer 70: 50% oligomer (Ebecryl® 8311: 40% 20 nm nanosilica dispersed in an aliphatic urethane acrylate), 43.8% monomer (Sartomer Arkema SR531: cyclic trimethylolpropane formal acrylate), 0.2% photoinitiator (MBF: methyl benzoylformate), 3.0% silane adhesion promoter (APTMS: 3-acryloxypropytrimethoxysilane), and 3.0% adhesion promoter (Sartomer Arkema CD9053: acrylate phosphate esters in TMPEOTA). In another preferred example, an epoxy having the following composition can be employed for the protect layer 70: 70.69% Nanopox® C-620 (cycloaliphatic epoxy resin with 40% by weight 20 nm spherical nanosilica), 23.56% Nanopox® C-680 (oxetane monomer with 50% by weight 20 nm spherical nanosilica), 3.00% Momentive™ CoatOSil® MP-200 (silane adhesion promoter), 2.50% Dow Chemical Cyracure UVI-6976™ (cationic photoinitiator), and 0.25% Ciba™ Tinuvin® 292 (hindered amine light stabilizer). The protect layer 70 can also comprise a polymeric layer, film or sheet bonded to the surface of the glass element 50 by an adhesive layer having the same or a similar thickness.

The bendable stack assembly 100 depicted in FIGS. 2-2B can be configured with a glass element 50 having a flaw distribution indicative of enhanced strength values. In certain implementations, the first primary surface 54 and a region 60 between the first primary surface 54 and about half of the final thickness 62 defines a substantially flaw-free region having a flaw distribution characterized by a plurality of flaws having an average longest cross-sectional dimension of about 200 nm or less. In some aspects, the substantially flaw-free region 60 can span to various depths (e.g., from 1/3 to 2/3 of the thickness 52 of the glass element 50) within the element 50, depending on the processing conditions used to create the reduced flaw sizes within the region 60.

According to other aspects of the disclosure, the bendable stack assembly 100 depicted in FIGS. 2-2B can include a glass element 50 that has been formed with a fusion process and the elastic modulus of the element is between about 40 GPa to about 65 GPa. Accordingly, the glass element 50 can include a fusion line (not shown). In certain aspects, the glass element 50 can be characterized by a fictive temperature between 700°C and 800°C at a viscosity of about $10^{10}$ Pa·s, preferably prepared using a fusion process. These fictive temperatures are generally higher than the fictive temperatures of most alkali-free glass compositions and result in lower elastic modulus values compared to compositions that are prepared using float processes and annealed. Alkali-free glass compositions that are prepared by float processes are less desirable as they often have a higher elastic modulus compared to glass elements prepared using a fusion process.

In another implementation of the bendable stack assembly 100 depicted in FIGS. 2-2B, the assembly 100 includes a glass element 50 having a composition substantially free of alkali ions, an elastic modulus of about 40 GPa to about 100 GPa, a $K_{IC}$ fracture toughness of at least 0.6 MPa·m$^{1/2}$, and a thickness 52 from about 20 μm to about 100 μm. The glass element 50 also includes a first primary surface 54 substantially in tension upon a bending 10 of the element 50, and a second primary surface 56 substantially in compression upon the bending 10. The glass element 50 also includes a protect layer 70 on the first primary surface 54.

In certain aspects of the bendable stack assembly 100, as depicted in FIGS. 2-2B, a glass element 50 has a composition substantially free of alkali ions, an elastic modulus of about 40 GPa to about 100 GPa, and a final thickness 52 from about 20 μm to about 100 μm. The glass element 50 also includes a first primary surface 54 that is substantially in tension upon a bending 10 of the element 50, and a second primary surface 56 substantially in compression upon the bending 10. In this aspect, the primary surfaces 54, 56 are characterized by a prior material removal to the final thickness 52 from an initial thickness that is at least 20 μm greater than the final thickness 52. The glass element 50 also includes a protect layer 70 on the first primary surface 54. In addition, the glass element 50 is characterized by an absence of failure after the element has been subjected to 200,000 cycles of the bending at a bend radius 40 of about 15 mm at about 25°C and about 50% relative humidity.

The bendable stack assembly 100 depicted in FIGS. 2-2B can also be configured with a glass element 50 having a composition substantially free of alkali ions, an elastic modulus of about 40 GPa to about 100 GPa, a final thickness 52 from about 20 μm to about 100 μm, and a bend strength of at least 1000 MPa at a failure probability of 2% or greater. The glass element 50 also includes a first primary surface 54 substantially in tension upon a bending 10 of the element 50, and a second primary surface 56 substantially in compression upon the bending 10. In this configuration, the primary surfaces 54, 56 are characterized by a prior material removal to the final thickness 52 from an initial thickness that is at least 20 $\mu$m greater than the final thickness. The glass element 50 also includes a protect layer 70 on the first primary surface 54. In addition, the glass element is characterized by a retained strength of at least 90% of the bend strength after the assembly 100 has been subjected to an indentation in the portion of the protect layer 70 laminated to the first primary surface 54 by a cube corner indenter at 10 gf.

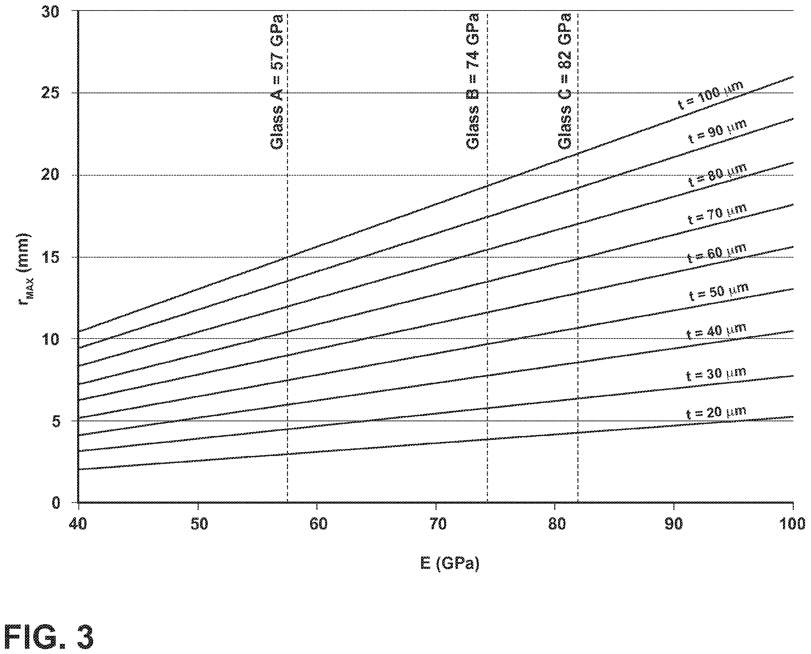

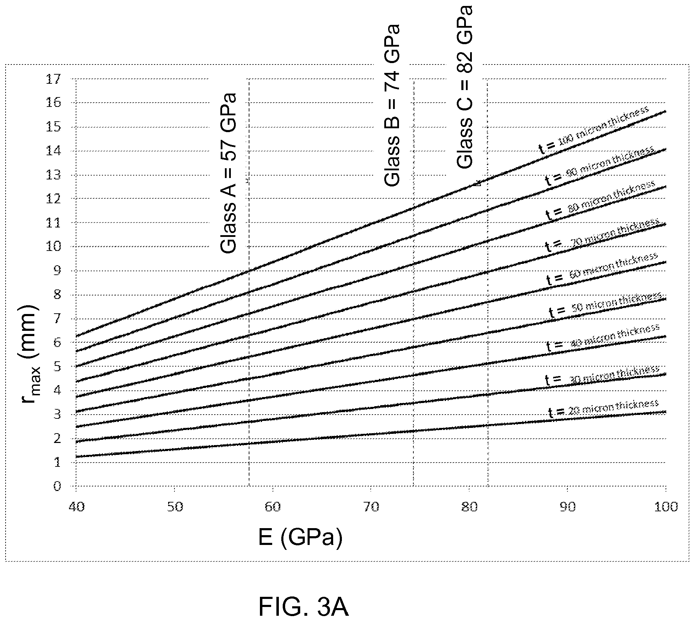

As demonstrated by FIG. 3, bendable stack assemblies 100 having alkali-free glass elements of various thicknesses and elastic moduli can be employed to achieve bend radii of 25 mm or lower according to aspects of the disclosure. With expected strength levels of 1000 MPa or greater, fatigue failure resistance for estimated 10-year lifetimes can be obtained by maintaining tensile stresses at or below 1/5 the maximum strength value. Accordingly, bend radii that produce stress levels of 200 MPa or less should not be susceptible to fatigue-related failure in the alkali-free glass elements. More specifically, Equation (2) below was used to generate the solution space depicted in FIG. 3, assuming a maximum induced tensile stress, $\sigma_{max}$, of 200 MPa for the glass element employed in the stack assemblies 100:

$$R = (E*h) / (1-v^2)*2\sigma_{max} \tag{2}$$

where R = maximum bend radii of the stack assembly without fatigue-related failure, $h$ is the thickness of the glass element, E is the elastic modulus of the glass element and v is the Poisson's ratio for the alkali-free glass (assumed to be 0.2).

Referring to FIG. 3, it is evident that a bendable stack assembly 100 configured with a glass element 50 having an elastic modulus of about 82 GPA ("Glass C") and a thickness of about 100 microns is capable of maximum bend radii 40 of about 22 mm. Decreasing the thickness to 20 microns, for example, improves the maximum bend radii to about 4 mm (i.e., a sharper bend is feasible). Similarly, a bendable stack assembly 100 configured with a glass element 50 having a lower elastic modulus of about 74 GPA ("Glass B") and a thickness of about 100 microns is capable of maximum bend radii 40 of about 18 mm. Decreasing the thickness to 20 microns, for example, improves the maximum bend radii to below 4 mm. Further, a bendable stack assembly 100 configured with a glass element 50 having an elastic modulus of about 57 GPA ("Glass A") and a thickness of about 100 microns is capable of maximum bend radii 40 of about 15 mm. Decreasing the thickness to 20 microns, for example, improves the maximum bend radii to about 3 mm.

As demonstrated by FIG. 3A, bendable stack assemblies 100 having alkali-free glass elements of various thicknesses and elastic moduli can be employed to achieve bend radii of 15 mm or lower according to aspects of the disclosure. With expected strength levels of 1000 MPa or greater, fatigue failure resistance for estimated 10-year lifetimes can be obtained by maintaining tensile stresses at or below 1/3 the maximum strength value. Accordingly, bend radii that produce stress levels of 333 MPa or less should not be susceptible to fatigue-related failure in the alkali-free glass elements. More specifically, Equation (2) below was used to generate the solution space depicted in FIG. 3A, assuming a maximum induced tensile stress, $\sigma_{max}$, of 333 MPa for the glass element employed in the stack assemblies 100:

$$R = (E*h) / (1-v^2)*2\sigma_{max} \tag{2}$$

where R = maximum bend radii of the stack assembly without fatigue-related failure, $h$ is the thickness of the glass element, E is the elastic modulus of the glass element and v is the Poisson's ratio for the alkali-free glass (assumed to be 0.2).

Referring to FIG. 3A, it is evident that a bendable stack assembly 100 configured with a glass element 50 having an elastic modulus of about 82 GPA ("Glass C") and a thickness of about 100 microns is capable of maximum bend radii 40 of about 13 mm. Decreasing the thickness to 20 microns, for example, improves the maximum bend radii to about 2.5 mm (i.e., a sharper bend is feasible). Similarly, a bendable stack assembly 100 configured with a glass element 50 having a lower elastic modulus of about 74 GPA ("Glass B") and a thickness of about 100 microns is capable of maximum bend radii 40 of about 11.5 mm. Decreasing the thickness to 20 microns, for example, improves the maximum bend radii to below 2.5 mm. Further, a bendable stack assembly 100 configured with a glass element 50 having an elastic modulus of about 57 GPA ("Glass A") and a thickness of about 100 microns is capable of maximum bend radii 40 of about 9 mm. Decreasing the thickness to 20 microns, for example, improves the maximum bend radii to less than 2 mm.

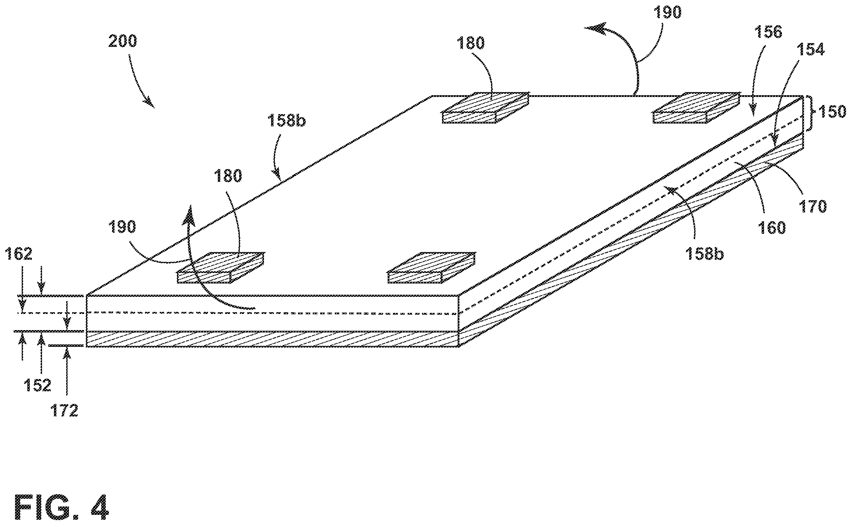

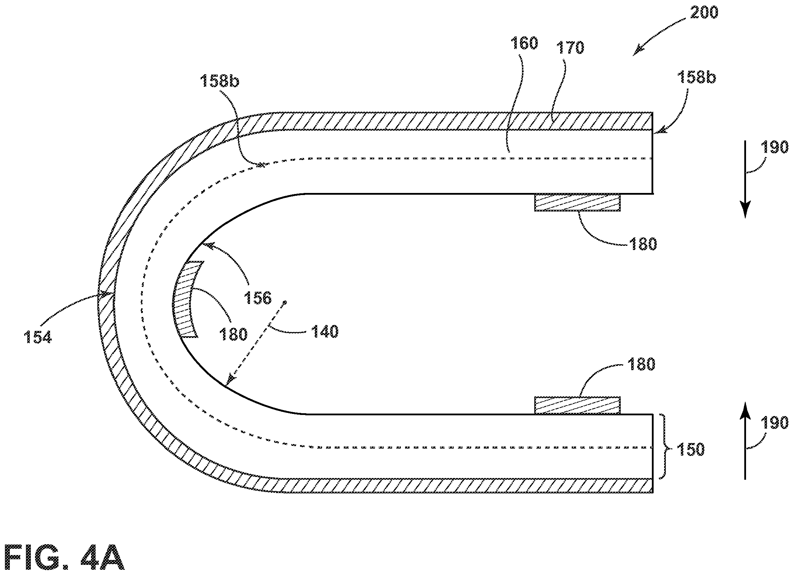

Referring to FIGS. 4-4A, a bendable electronic device assembly 200 is provided that includes a bendable backplane 150 having a glass composition substantially free of alkali ions, an elastic modulus of about 40 GPa to about 100 GPa, and a final thickness 152 from about 20 $\mu$m to about 100 $\mu$m. The bendable backplane 150 has a first primary surface 154 substantially in tension upon a bending 190 of the backplane 150, and a second primary surface 156 substantially in compression upon the bending 190. Further, the primary surfaces 154, 156 are characterized by a prior material removal to the final thickness 152 from an initial thickness that is at least 20 μm greater than the final thickness 152. The assembly 200 also includes a protect layer 170 on the first primary surface 154 of the backplane 150; and a plurality of electronic components 180 on the second primary surface 156 of the backplane 150. In addition, the backplane 150 is characterized by an absence of failure when the backplane is held during the bending 190 at a bend radius 140 of about 15 mm for at least 60 minutes at about 25°C and about 50% relative humidity.

As depicted in FIG. 4A, the assembly 200 can be flexed or bent according to the bend direction 190 such that the first primary surface 154 is placed in tension and the second primary surface 156 containing the electronic components 180 is in compression. Consequently, the protect layer 170 is placed over the primary surface 154 in tension to ensure that handling-related defects do not develop in that surface that could lead to a strength reduction and, ultimately, a reduction in fatigue life performance for a given bend radius 140. It should be recognized that the bendable backplane 150, substantially flaw-free region 160, and protect layer 170 components of the bendable electronic assembly are comparable to the glass element 50, substantially flaw-free region 60 and protect layer 70 employed in the bendable stack assembly 100 depicted in FIGS. 2-2B. As such, the earlier-described variants of the stack assembly 100 are also applicable to the bendable electronic device assembly 200.

In some aspects, the electronic components 180 comprise at least one thin film transistor (TFT) element or at least one organic light-emitting diode (OLED) element. When temperature-resistant protect layer 170 compositions are employed in the device assemblies 200, higher temperature processing of the electronic components 180 on the backplane 150 can be employed compared to systems having a polymer backplane. Advantageously, the increased temperature capability of device assemblies 200 can be used to realize higher manufacturing yields and/or the integration of higher performance electronic device components into the device housing the backplane.

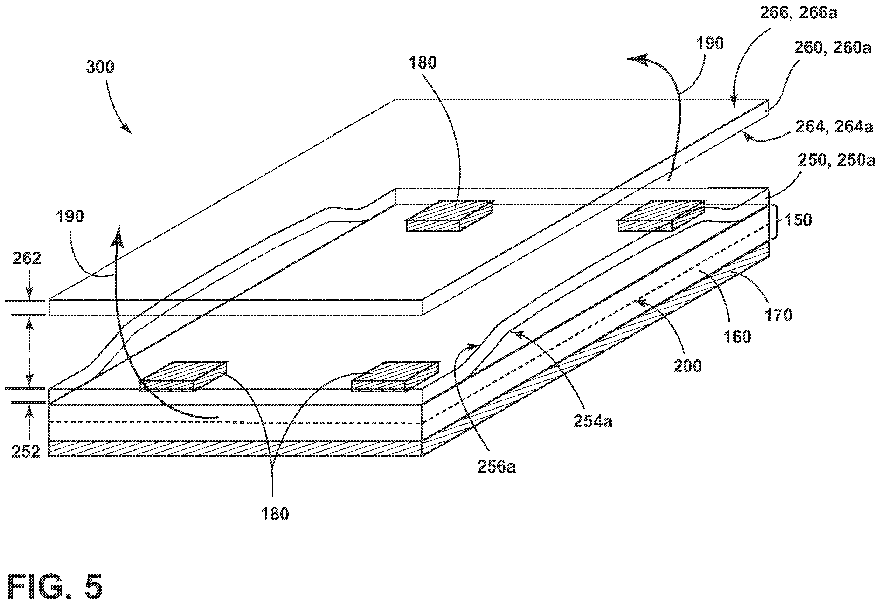

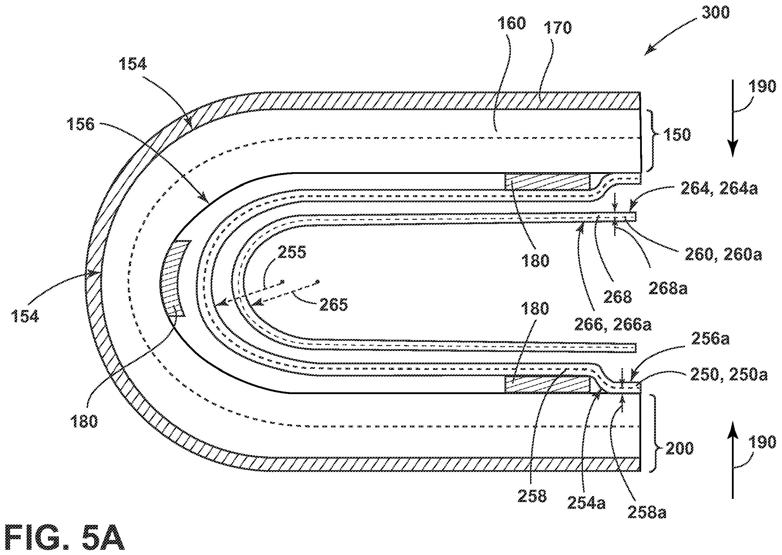

Referring to FIGS. 5-5A, a bendable electronic device assembly 300 is depicted that employs a device assembly 200 comparable to the assembly depicted in FIGS. 4-4A. In particular, the assembly 300 further includes a bendable cover 260 over the plurality of electronic components 180. The cover 260 can have a thickness from about 25 μm to about 125 μm, a first primary surface 264 and a second primary surface 266. The cover 260 also includes (a) a first glass layer 260a having an optical transmissivity of at least 90%, a first primary surface 264a and a second primary surface 266a; and (b) a compressive stress region 268 extending from the first primary surface 264a of the first glass layer 260a to a first depth 268a in the first glass layer, the region 268 defined by a compressive stress of at least about 100 MPa at the first primary surface 264a of the first glass layer 260a.

In addition, the bendable cover 260 of the bendable electronic device assembly 300 is also characterized by: (a) an absence of failure when the cover 260 is held at a bend radius 265 of about 15 mm for at least 60 minutes at about 25°C and about 50% relative humidity by bend forces 190; (b) a puncture resistance of greater than about 1.5 kgf when the first primary surface 264 of the cover 260 is supported by (i) an approximately 25 μm thick pressure-sensitive adhesive having an elastic modulus of less than about 1 GPa and (ii) an approximately 50 μm thick polyethylene terephthalate layer having an elastic modulus of less than about 10 GPa, and the second primary surface 266 of the cover 260 is loaded with a stainless steel pin having a flat bottom with a 200 μm diameter; and (c) a pencil hardness of greater than or equal to 8H. As shown in FIGS. 5-5A, the compressive stress region 268 is located in the portion of the cover 260 likely subjected to tensile stresses associated with the bend forces 190. But it should be understood that the compressive stress region 268 may also be placed in other locations of the cover 260, essentially in any regions expected to experience tensile stresses in the application environment or other areas where high strength levels can benefit the cover (e.g., surfaces exposed to handling from users of the device containing the device assembly 300).

In certain aspects of the bendable cover 260, the thickness 262 can range from about 25 μm to about 125 μm. In other aspects, the thickness 262 can range from about 50 μm to about 100 μm, or about 60 μm to about 80 μm. Other thickness values can be employed within the foregoing ranges for the thickness 262 of the bendable cover 260.

In some embodiments of the bendable cover 260, it contains a single glass layer 260a having a thickness 262a comparable to the thickness 262 of the cover 260. In other aspects, the cover 260 can contain two or more glass layers 260a. Consequently, the thickness 262a of each glass layer 260a can range from about 1 μm to about 125 μm. It should also be understood that the bendable glass cover 260 can include other non-glass layers (e.g., compliant, polymeric layers) in addition to one or more glass layers 260a.

With further regard to the glass layer(s) 260a of the bendable glass cover 260, each glass layer 260a can be fabricated from alkali-free aluminosilicate, borosilicate, boroaluminosilicate, and silicate glass compositions. Each glass layer 260a can also be fabricated from alkali-containing aluminosilicate, borosilicate, boroaluminosilicate, and silicate glass compositions. In certain aspects, alkaline earth modifiers can be added to any of the foregoing compositions. In one exemplary aspect, glass compositions according to the following are suitable for the glass layer 260a: $SiO_2$ at 64 to 69% (by mol%); $Al_2O_3$ at 5 to 12%; $B_2O_3$ at 8 to 23%; MgO at 0.5 to 2.5%; CaO at 1 to 9%; SrO at 0 to 5%; BaO at 0 to 5%; $SnO_2$ at 0.1 to 0.4%; $ZrO_2$ at 0 to 0.1%; and $Na_2O$ at 0 to 1%. In another exemplary aspect, the following composition is suitable for the glass layer 50a: $SiO_2$ at ~67.4% (by mol%); $Al_2O_3$ at ~12.7%; $B_2O_3$ at ~3.7%; MgO at ~2.4%; CaO at 0%; SrO at 0%; $SnO_2$ at ~0.1%; and $Na_2O$ at ~13.7%. In a further exemplary aspect, the following composition is also suitable for the glass layer 260a: $SiO_2$ at 68.9% (by mol%); $Al_2O_3$ at 10.3%; $Na_2O$ at 15.2%; MgO at 5.4 %; and $SnO_2$ at 0.2%. In some aspects, a composition for glass layer 260a is selected with a relatively low elastic modulus (compared to other alternative glasses). Lower elastic modulus in the glass layer 260a can reduce the tensile stress in the layer 260a during bending. Other criteria can be used to select the composition for glass layer 260a, including but not limited to ease of manufacturing to low thickness levels while minimizing the incorporation of flaws, ease of development of a compressive stress region to offset tensile stresses generated during bending, optical transparency, and corrosion resistance.

Still referring to FIGS. 5 and 5A, the bendable cover 260 of the electronic device assembly 300 further includes a compressive stress region 268 that extends from the first primary surface 264a of the glass layer 260a to a first depth 268a in the glass layer 260a. Among other advantages, the compressive stress region 268 can be employed within the glass layer 260a to offset tensile stresses generated in the glass layer 260a upon bending, particularly tensile stresses that reach a maximum near the first primary surface 264a. The compressive stress region 268 can include a compressive stress of at least about 100 MPa at the first primary surface of the layer 264a. In some aspects, the compressive stress at the first primary surface 264a is from about 600 MPa to about 1000 MPa. In other aspects, the compressive stress can exceed 1000 MPa at the first primary surface 264a, up to 2000 MPa, depending on the process employed to produce the compressive stress in the glass layer 260a. The compressive stress can also range from about 100 MPa to about 600 MPa at the first primary surface 264a in other aspects of this disclosure.

Within the compressive stress region 268, the compressive stress can stay constant, decrease or increase within the glass layer 260a as a function of depth from the first primary surface of the glass layer 264a down to the first depth 268a. As such, various compressive stress profiles can be employed in compressive stress region 268. Further, the depth 268a can be set at approximately 15 $\mu$m or less from the first primary surface of the glass layer 264a. In other aspects, the depth 268a can be set such that it is approximately 1/3 of the thickness of the glass layer 260a or less, or 20% of the thickness of the glass layer 260a or less, from the first primary surface of the glass layer 264a.

Referring to FIGS. 5 and 5A, the bendable cover 260 is characterized by an absence of failure when the element is held at the bend radius 265 from of about 15 mm for at least 60 minutes at about 25°C and about 50% relative humidity. In some aspects, the bend radius 265 can be set at about 10 mm, or about 5 mm in some other implementations. It is also feasible to set the bend radius 265 to values within about 25 mm and about 5 mm, depending on the needs of the application. As used herein, the terms "fail," "failure" and the like refer to breakage, destruction, delamination, crack propagation or other mechanisms that leave the stack assemblies, glass articles, and glass elements of this disclosure unsuitable for their intended purpose. When the bendable cover 260 is held at the bend radius 265 under these conditions, bending forces 190 are applied to the ends of the cover 260. In general, tensile stresses are generated at the first primary surface 264 of the cover 260 and compressive stresses are generated at the second primary surface 266 during the application of bending forces 190. It should also be understood that bend testing results can vary under testing conditions with temperatures and/or humidity levels that differ from the foregoing. For example, a bendable cover 260 having a smaller bend radii 265 (e.g., < 5 mm) may be characterized by an absence of failure in bend testing conducted at humidity levels significantly below 50% relative humidity.

The bendable cover 260 is also characterized by a puncture resistance of greater than about 1.5 kgf when the first primary surface 264 of the element 260 is supported by (i) an approximately 25 $\mu$m thick pressure-sensitive adhesive ("PSA") having an elastic modulus of less than about 1 GPa and (ii) an approximately 50 $\mu$m thick polyethylene terephthalate layer ("PET") having an elastic modulus of less than about 10 GPa, and the second primary surface 266 of the cover 260 is loaded with a stainless steel pin having a flat bottom with a 200 $\mu$m diameter (e.g., to simulate impacts to the cover 260 during use of the bendable electronic device assembly 300 in the application environment). Typically, puncture testing according to aspects of this disclosure is performed under displacement control at 0.5 mm/min crosshead speed. In certain aspects, the stainless steel pin is replaced with a new pin after a specified quantity of tests (e.g., 10 tests) to avoid bias that could result from deformation of the metal pin associated with the testing of materials possessing a higher elastic modulus (e.g., a glass bendable cover 260). In some aspects, the bendable cover 260 is characterized by a puncture resistance of greater than about 1.5 kgf at a 5% or greater failure probability within a Weibull plot. The bendable cover 260 can also be characterized by a puncture resistance of greater than about 3 kgf at the Weibull characteristic strength (i.e., a 63.2% or greater). In certain aspects, the cover 260 of the bendable electronic device assembly 300 can resist puncture at about 2 kgf or greater, 2.5 kgf or greater, 3 kgf or greater, 3.5 kgf or greater, 4 kgf or greater, and even higher ranges. The bendable cover 260 is also characterized by a pencil hardness of greater than or equal to 8H.

Referring to FIG. 5A, a cross-section of a bendable electronic device assembly 300 is depicted that relies on an ion exchange process to develop a compressive stress region 268 in the bendable cover 260. In some aspects of the assembly 300, the compressive stress region 268 of the cover 260 can be developed through an ion exchange process. That is, the compressive stress region 268 can include a plurality of ion-exchangeable metal ions and a plurality of ion-exchanged metal ions, the ion-exchanged metal ions selected so as to produce compressive stress in the region 268. In some aspects of electronic device assembly 300, the ion-exchanged metal ions have an atomic radius larger than the atomic radius of the ion-exchangeable metal ions. The ion-exchangeable ions (e.g., $Na^+$ ions) are present in the bendable cover 260 and the layer 260a before being subjected to the ion exchange process. Ion-exchanging ions (e.g., $K^+$ ions) can be incorporated into the cover 260 and one or more layers 260a, replacing some of the ion-exchangeable ions. The incorporation of ion-exchanging ions, for example, $K^+$ ions, into the cover 260 and the layer 260a can be effected by submersing the element or the layer in a molten salt bath containing ion-exchanging ions (e.g., molten $KNO_3$ salt). In this example, the $K^+$ ions have a larger atomic radius than the $Na^+$ ions and tend to generate local compressive stresses in the glass wherever present.

Depending on the ion-exchanging process conditions employed, the ion-exchanging ions can be imparted from the first primary surface 264a down to a first ion exchange depth 268a, establishing an ion exchange depth-of-layer ("DOL") for the compressive stress region 268. Compressive stress levels within the DOL that far exceed 100 MPa can be achieved with such ion exchange processes, up to as high as 2000 MPa. As noted earlier, the compressive stress levels in the compressive stress region 268 can serve to offset the tensile stresses generated in the cover 260 and one or more glass layers 260a generated from bending forces 190.

Other processing-related information and alternative configurations for the bendable cover 260 elements according to this disclosure can be obtained from the aspects of the bendable stack assemblies taught in U.S. Provisional Patent Application Nos. 61/932,924 and 61/974,732 (collectively, the "'924 and '732 applications"), filed on January 29, 2014 and April 3, 2014, respectively. For example, the device assemblies 300 can employ various glass compositions, including alkali-containing compositions, within the cover 260 since the cover 260 is not in direct contact with electronic components 180. In some other aspects of the device assemblies 300, the cover 260 can employ integrated electronic components (e.g., touch sensors) above the backplane 150 and the electronic components 180 mounted to the backplane. In such aspects, the cover 260 will preferably employ an alkali-free glass composition.

In some aspects of the bendable electronic device assembly 300 depicted in FIGS. 5-5A, the assembly further includes an encapsulant 250 beneath the cover 260 and joined to the backplane 150. The encapsulant 250 is configured to encapsulate the electronic components 180. The encapsulant can, in some aspects, be configured as an optically transparent polymeric sealing material. It should be understood, however, that the encapsulant 250 must have suitable mechanical integrity to function as an encapsulant without failure when the assembly 300 is subjected to bending forces 190 as shown in FIG. 5A.

Referring again to FIGS. 5-5A, another aspect of the bendable electronic device assembly 300 employs an encapsulant 250 in the form of a bendable glass layer having a thickness 252 from about 25 $\mu$m to about 125 $\mu$m that further includes: (a) a second glass layer 250a having an optical transmissivity of at least 90%, a first primary surface 254a and a second primary surface 256a; and (b) a compressive stress region 258 extending from the first primary surface 254a of the second glass layer 250a to a first depth 258a in the second glass layer 250a, the region 258 defined by a compressive stress of at least about 100 MPa at the first primary surface 254a of the second glass layer. The encapsulant 250 is further characterized by an absence of failure when the encapsulant is held by bend forces 190 at a bend radius 255 of about 15 mm for at least 60 minutes at about 25°C and about 50% relative humidity. As such, the encapsulant 250 can be configured identically or similar to the bendable glass cover 260 described in the foregoing sections.

For some aspects of the bendable electronic device assemblies 300, the puncture resistance and pencil hardness requirements specified in connection with the bendable glass cover 260 are not controlling with regard to the encapsulant 250. That is, the encapsulant 250 is not likely subject to direct handling by manufacturing personnel or device owners, thus reducing the importance of high puncture resistance and pencil hardness. In certain other aspects of the disclosure, the encapsulant 250 can include a glass composition substantially free of alkali ions, as discussed above. These aspects of the assemblies 300 generally require close contact between the encapsulant 250 and the underlying electronic components 180. Although FIG. 5 schematically depicts only two of the four perimeter edges of the encapsulant 250 as sealed to the backplane 150 of device assembly 200, in practice all four perimeter edges will be sealed to create a hermetic environment for the electronic components 180. The encapsulant 250 may be sealed to the backplane 150 by frit sealing, as is known in the art.

In certain implementations of the bendable electronic device assemblies 300, the assembly has a total thickness of 375 microns or less, 350 microns or less, 325 microns or less, 300 microns or less, 275 microns or less, 250 microns or less, 225 microns or less, or 200 microns or less. The total thickness of the bendable electronic device assembly generally depends on the respective thicknesses of the backplane 150, encapsulant 250, cover 260 and protect layer 170. As outlined earlier, the thickness of the backplane can depend on the degree of the processing conditions associated with the prior material removal.

It will be apparent to those skilled in the art that various modifications and variations can be made without departing from the spirit and scope of the claims. For example, the bendable stack assembly 100 depicted in FIGS. 2-2B includes a protect layer 70 on the primary surface 254, expected to be in tension from the bending force 10. Yet other variants are possible in which the protect layer 70 is employed on additional surfaces of the glass element 50 (not shown) employed in the stack assembly 100 expected to experience tensile stresses from application-oriented bending.

**Claims**

1. A bendable stack assembly, comprising:

   a glass element (50, 150) having a composition substantially free of alkali ions,

   an elastic modulus of about 40 GPa to about 100 GPa,
   a final thickness from about 20 $\mu$m to about 100 $\mu$m,
   a bend strength of at least 1000 MPa at a failure probability of 2% or greater,
   a first primary surface (54, 154) substantially in tension upon a bending of the element, and
   a second primary surface (56, 156) substantially in compression upon the bending, the primary surfaces **characterized by** a prior material removal to the final thickness from an initial thickness that is at least 20 $\mu$m greater than the final thickness; and

   a protect layer (70, 170) on the first primary surface (54, 154), wherein the protect layer (70, 170) comprises nano-silica particulate and at least one of epoxy and urethane materials;
   wherein the glass element (50, 150) is **characterized by** a retained strength of at least 90% of the bend strength after the assembly has been subjected to an indentation in the portion of the protect layer (70, 170) laminated to the first primary surface (54, 154) by a cube corner indenter at 10 gf.

2. The bendable stack assembly according to claim 1, wherein the protect layer (70, 170) has a thickness of at least 5 $\mu$m.

3. The bendable stack assembly according to claim 1 or 2, wherein the first primary surface (54, 154) and a region of the element between the first primary surface (54, 154) and half of the final thickness defines a substantially flaw-free region having a flaw distribution **characterized by** a plurality of flaws having an average longest cross-sectional dimension of about 200 nm or less.

4. The bendable stack assembly according to any one of claims 1-3, wherein the glass element (50, 150) has a fusion line and the elastic modulus of the glass element is about 40 GPa to about 65 GPa.

5. The bendable stack assembly according to claim 4, wherein the glass element (50, 150) is further **characterized by** a fictive temperature between 700°C and 800°C at a viscosity of about $10^{10}$ Pa·s.

6. A bendable electronic device assembly, comprising:

   a bendable backplane (50, 150) having a glass composition substantially free of alkali ions,

   an elastic modulus of about 40 GPa to about 100 GPa,
   a bend strength of at least 1000 MPa at a failure probability of 2% or greater,
   a final thickness from about 20 $\mu$m to about 100 $\mu$m,
   a first primary surface (54, 154) substantially in tension upon a bending of the backplane, and
   a second primary surface (56, 156) substantially in compression upon the bending, the primary surfaces (54, 154) **characterized by** a prior material removal to the final thickness from an initial thickness that is at least 20 $\mu$m greater than the final thickness;

   a protect layer (70, 170) on the first primary surface (54, 154) of the backplane (50, 150), wherein the protect layer (70, 170) comprises nano-silica particulate and at least one of epoxy and urethane materials; and
   a plurality of electronic components (180) on the second primary surface (56, 156) of the backplane,
   wherein the backplane (50, 150) is **characterized by** an absence of failure when the backplane is held during the bending at a bend radius of about 15 mm for at least 60 minutes at about 25°C and about 50% relative humidity and a retained strength of at least 90% of the bend strength after the assembly has been subjected to an indentation in the portion of the protect layer (70, 170) laminated to the first primary surface (54, 154) by a cube corner indenter at 10 gf.

7. The bendable electronic device assembly according to claim 6, wherein the composition of the backplane has less than 0.5 mol% of each of $Li_2O$, $Na_2O$, $K_2O$, $Rb_2O$ and $Cs_2O$.

8. The bendable electronic device assembly according to claim 6 or 7, wherein the electronic components (180)

comprise at least one thin film transistor element or at least one OLED element.

**Patentansprüche**

1.  Biegbare Schichtungsanordnung, aufweisend:

    ein Glaselement (50, 150) mit einer Zusammensetzung, die im Wesentlichen frei von Alkaliionen ist,

    einem Elastizitätsmodul von etwa 40 GPa bis etwa 100 GPa,
    einer Enddicke von etwa 20 $\mu$m bis etwa 100 $\mu$m,
    einer Biegefestigkeit von zumindest 1000 MPa bei einer Versagenswahrscheinlichkeit von 2 % oder höher,
    einer ersten Hauptfläche (54, 154), die bei einem Biegen des Elements im Wesentlichen auf Zug beansprucht wird, und
    einer zweiten Hauptfläche (56, 156), die bei dem Biegen im Wesentlichen auf Druck beansprucht wird, wobei die Hauptflächen durch eine vorherige Materialabtragung bis zu der Enddicke ausgehend von einer Anfangsdicke, die zumindest 20 $\mu$m größer als die Enddicke ist, gekennzeichnet sind; und

    eine Schutzschicht (70, 170) auf der ersten Hauptfläche (54, 154), wobei die Schutzschicht (70, 170) Nano-Siliciumdioxid-Partikelmaterial und zumindest eines aus Epoxid- und Urethanmaterial aufweist;
    wobei das Glaselement (50, 150) **gekennzeichnet ist durch** eine Restfestigkeit von zumindest 90 % der Biegefestigkeit, nachdem eine Indentierung der Anordnung im Abschnitt der auf die erste Hauptfläche (54, 154) laminierten Schutzschicht (70, 170) mittels eines Cube-Corner-Indenters mit 10 gf vorgenommen wurde.

2.  Biegbare Schichtungsanordnung nach Anspruch 1, wobei die Schutzschicht (70, 170) eine Dicke von zumindest 5 $\mu$m aufweist.

3.  Biegbare Schichtungsanordnung nach Anspruch 1 oder 2, wobei die erste Hauptfläche (54, 154) und ein Bereich des Elements zwischen der ersten Hauptfläche (54, 154) und der halben Enddicke einen im Wesentlichen fehlerfreien Bereich definieren, der eine Fehlerverteilung aufweist, die durch eine Mehrzahl von Fehlern mit einer durchschnittlichen längsten Querschnittsabmessung von etwa 200 nm oder kleiner gekennzeichnet ist.

4.  Biegbare Schichtungsanordnung nach einem der Ansprüche 1-3, wobei das Glaselement (50, 150) eine Schmelzlinie aufweist und der Elastizitätsmodul des Glaselements etwa 40 GPa bis etwa 65 GPa beträgt.

5.  Biegbare Schichtungsanordnung nach Anspruch 4, wobei das Glaselement (50, 150) ferner durch eine fiktive Temperatur zwischen 700 °C und 800 °C bei einer Viskosität von etwa $10^{10}$ Pa·s gekennzeichnet ist.

6.  Biegbare Anordnung für eine elektronische Vorrichtung, aufweisend:

    eine biegbare Rückwand (50, 150) mit einer Glaszusammensetzung, die im Wesentlichen frei von Alkaliionen ist,

    einem Elastizitätsmodul von etwa 40 GPa bis etwa 100 GPa,
    einer Biegefestigkeit von zumindest 1000 MPa bei einer Versagenswahrscheinlichkeit von 2 % oder höher,
    einer Enddicke von etwa 20 $\mu$m bis etwa 100 $\mu$m,
    einer ersten Hauptfläche (54, 154), die bei einem Biegen der Rückwand im Wesentlichen auf Zug beansprucht wird, und
    einer zweiten Hauptfläche (56, 156), die bei dem Biegen im Wesentlichen auf Druck beansprucht wird, wobei die Hauptflächen (54, 154) durch eine vorherige Materialabtragung bis zu der Enddicke ausgehend von einer Anfangsdicke, die zumindest 20 $\mu$m größer als die Enddicke ist, gekennzeichnet sind;

    eine Schutzschicht (70, 170) auf der ersten Hauptfläche (54, 154) der Rückwand (50, 150), wobei die Schutzschicht (70, 170) Nano-Siliciumdioxid-Partikelmaterial und zumindest eines aus Epoxid- und Urethanmaterial aufweist; und
    eine Mehrzahl elektronischer Komponenten (180) auf der zweiten Hauptfläche (56, 156) der Rückwand,
    wobei die Rückwand (50, 150) **gekennzeichnet ist durch** ein Nichtversagen, wenn die Rückwand während des Biegens zumindest 60 Minuten lang bei etwa 25 °C und etwa 50 % relativer Feuchtigkeit mit einem Biegeradius von etwa 15 mm gehalten wird, und eine Restfestigkeit von zumindest 90 % der Biegefestigkeit, nachdem eine Indentierung der Anordnung im Abschnitt der auf die erste Hauptfläche (54, 154) laminierten Schutzschicht (70, 170) mittels eines Cube-Corner-Indenters mit 10 gf vorgenommen wurde.

**7.** Biegbare Anordnung für eine elektronische Vorrichtung nach Anspruch 6, wobei die Zusammensetzung der Rückwand weniger als 0,5 Mol-% jedes von $Li_2O$, $Na_2O$, $K_2O$, $Rb_2O$ und $Cs_2O$ aufweist.

**8.** Biegbare Anordnung für eine elektronische Vorrichtung nach Anspruch 6 oder 7, wobei die elektronischen Komponenten (180) zumindest ein Dünnschichttransistor-Element oder zumindest ein OLED-Element aufweisen.

**Revendications**

**1.** Ensemble d'empilement pliable, comprenant :

un élément en verre (50, 150) ayant une composition sensiblement exempte d'ions alcalins,

un module d'élasticité d'environ 40 GPa à environ 100 GPa,
une épaisseur finale d'environ 20 $\mu$m à environ 100 $\mu$m,
une résistance au pliage d'au moins 1000 MPa avec une probabilité de défaillance de 2 % ou plus,
une première surface primaire (54, 154) sensiblement en tension lors d'une flexion de l'élément, et
une seconde surface primaire (56, 156) sensiblement en compression lors du pliage, les surfaces primaires étant **caractérisées par** un retrait de matériau préalable jusqu'à l'épaisseur finale à partir d'une épaisseur initiale qui est au moins 20 $\mu$m supérieure à l'épaisseur finale ; et une couche de protection (70, 170) sur la première surface primaire (54, 154), la couche de protection (70, 170) comprenant des particules de nanosilice et au moins un matériau parmi des matériaux époxy et uréthane ;

l'élément en verre (50, 150) étant **caractérisé par** une résistance rémanente d'au moins 90 % de la résistance au pliage après que l'ensemble a été soumis à une indentation dans la partie de la couche de protection (70, 170) laminée sur la première surface primaire (54, 154) par un dispositif d'indentation à coin cubique à 10 gf.

**2.** Ensemble d'empilement pliable selon la revendication 1, la couche de protection (70, 170) ayant une épaisseur d'au moins 5 $\mu$m.

**3.** Ensemble d'empilement pliable selon la revendication 1 ou 2, la première surface primaire (54, 154) et une région de l'élément entre la première surface primaire (54, 154) et la moitié de l'épaisseur finale définissant une région sensiblement exempte de défauts ayant une distribution de défauts **caractérisée par** une pluralité de défauts ayant une dimension de section transversale moyenne la plus longue, d'environ 200 nm ou moins.

**4.** Ensemble d'empilement pliable selon l'une quelconque des revendications 1 à 3, l'élément en verre (50, 150) ayant une ligne de fusion et le module élastique de l'élément en verre étant d'environ 40 GPa à environ 65 GPa.

**5.** Ensemble d'empilement pliable selon la revendication 4, l'élément en verre (50, 150) étant en outre **caractérisé par** une température fictive entre 700 °C et 800 °C à une viscosité d'environ $10^{10}$ Pa·s.

**6.** Ensemble de dispositif électronique pliable, comprenant :

un fond de panier pliable (50, 150) ayant une composition de verre sensiblement exempte d'ions alcalins,

un module d'élasticité d'environ 40 GPa à environ 100 GPa,
une résistance au pliage d'au moins 1000 MPa avec une probabilité de défaillance égale ou supérieure à 2%,
une épaisseur finale d'environ 20 $\mu$m à environ 100 $\mu$m,
une première surface primaire (54, 154) sensiblement en tension lors d'une flexion du fond de panier, et
une seconde surface primaire (56, 156) sensiblement en compression lors du pliage, les surfaces primaires (54, 154) étant **caractérisées par** un retrait de matériau préalable jusqu'à l'épaisseur finale à partir d'une épaisseur initiale qui est au moins 20 $\mu$m supérieure à l'épaisseur finale ;

une couche de protection (70, 170) sur la première surface primaire (54, 154) du fond de panier (50, 150), la couche de protection (70, 170) comprenant des particules de nanosilice et au moins un matériau parmi des matériaux époxy et uréthane ; et

une pluralité de composants électroniques (180) sur la seconde surface primaire (56, 156) du fond de panier, le fond de panier (50, 150) étant **caractérisé par** une absence de défaillance lorsque le fond de panier est maintenu pendant le pliage à un rayon de pliage d'environ 15 mm pendant au moins 60 minutes à environ 25 °C et environ 50 % d'humidité relative et une résistance rémanente d'au moins 90 % de la résistance au pliage après que l'ensemble a été soumis à une indentation dans la partie de la couche de protection (70, 170) laminée sur la première surface primaire (54, 154) par un dispositif d'indentation à coin cubique à 10 gf.

7. Ensemble de dispositif électronique pliable selon la revendication 6, la composition du fond de panier ayant moins de 0,5 % en moles de chacun de $Li_2O$, $Na_2O$, $K_2O$, $Rb_2O$ et $Cs_2O$.

8. Ensemble de dispositif électronique pliable selon la revendication 6 ou 7, les composants électroniques (180) comprenant au moins un élément transistor à couche mince ou au moins un élément OLED.

FIG. 1

FIG. 2

FIG. 2A

FIG. 2B

**FIG. 3**

FIG. 3A

FIG. 4

FIG. 4A

EP 3 215 472 B1

**FIG. 5**

EP 3 215 472 B1

FIG. 5A

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 62074940
- US 2013109116 A1
- US 2012040146 A1
- WO 2013183681 A1
- US 2012263945 A1
- US 2012223049 A1
- US 51668514
- US 61932924
- US 61974732 B